# EUROPÄISCHE PATENTSCHRIFT

(11) **EP 1 649 497 B1**
(45) Veröffentlichungstag und Bekanntmachung des Hinweises auf die Patenterteilung: **29.04.2015**
(21) Anmeldenummer: 04762443.2
(22) Anmeldetag: 22.07.2004
(51) Int. Cl.: H01L 21/02, H01L 21/20, H01L 33/00

(54) **VERFAHREN ZUR HERSTELLUNG EINER VIELZAHL VON OPTOELEKTRONISCHEN HALBLEITERCHIPS UND OPTOELEKTRONISCHER HALBLEITERCHIP**
METHOD FOR THE PRODUCTION OF A PLURALITY OF OPTO-ELECTRONIC SEMICONDUCTOR CHIPS AND OPTO-ELECTRONIC SEMICONDUCTOR CHIP
PROCEDE DE FABRICATION D'UNE PLURALITE DE PUCES A SEMI-CONDUCTEUR OPTOELECTRONIQUES ET PUCE A SEMI-CONDUCTEUR OPTOELECTRONIQUE AINSI OBTENUE

(30) Priorität: 31.07.2003 DE 10335080
(43) Veröffentlichungstag der Anmeldung: 26.04.2006
(73) Patentinhaber: OSRAM Opto Semiconductors GmbH, 93055 Regensburg (DE)
(72) Erfinder: HÄRLE, Volker, 93164 Waldetzenberg (DE)
(74) Vertreter: Epping - Hermann - Fischer
(86) Internationale Anmeldenummer: PCT/DE2004/001593
(87) Internationale Veröffentlichungsnummer: WO 2005/013379

(56) Entgegenhaltungen:
- EP-A1- 0 388 733
- EP-A2- 0 472 221
- EP-A2- 1 005 067
- US-A- 6 110 277
- YANG J W ET AL: "Selective area deposited blue GaN–InGaN multiple-quantum well light emitting diodes over silicon substrates" APPLIED PHYSICS LETTERS, AMERICAN INSTITUTE OF PHYSICS. NEW YORK, US, Bd. 76, Nr. 3, 17. Januar 2000 (2000-01-17), Seiten 273-275, XP012025677 ISSN: 0003-6951
- MIYATA NORIYUKI ET AL: "Selective growth of nanocrystalline Si dots using an ultrathin-Si-oxide/oxynitride mask" APPLIED PHYSICS LETTERS, AMERICAN INSTITUTE OF PHYSICS. NEW YORK, US, Bd. 77, Nr. 11, 11. September 2000 (2000-09-11), Seiten 1620-1622, XP012026105 ISSN: 0003-6951
- PATENT ABSTRACTS OF JAPAN Bd. 017, Nr. 676 (E-1475), 13. Dezember 1993 (1993-12-13) -& JP 05 226781 A (FUJITSU LTD), 3. September 1993 (1993-09-03)

## Beschreibung

Diese Patentanmeldung beansprucht die Priorität der deutschen Patentanmeldung 10335080.2, deren Offenbarungsgehalt hiermit durch Rückbezug aufgenommen wird.

Die Erfindung betrifft ein Verfahren zur Herstellung einer Vielzahl optoelektronischer Halbleiterchips, die jeweils eine Vielzahl von Strukturelementen mit jeweils mindestens einer Halbleiterschicht aufweisen. Halbleiterschichten der Strukturelemente werden dabei mittels selektiver Epitaxie aufgewachsen. Zudem betrifft die Erfindung einen nach diesem Verfahren hergestellten optoelektronischen Halbleiterchip.

Ein derartiger optoelektronischer Halbleiterchip sowie ein entsprechendes Verfahren zu dessen Herstellung ist beispielsweise in der DE 199 11 717 A1 beschrieben. Dieser weist eine Vielzahl von Strahlungsauskoppelelementen auf, die z. B. eine epitaktisch gewachsene Halbleiterschichtfolge mit einer elektromagnetische Strahlung erzeugenden aktiven Schicht umfassen. Dadurch weist dieses Bauelement eine verbesserte Strahlungsauskopplung auf.

Jedes der Strahlungsauskoppelelemente weist auf einer Deckfläche einen Ringkontakt auf, wobei die Ringkontakte untereinander durch elektrisch leitende Stege verbunden sind. Dies ist eine relativ aufwendige Art, die Strahlungsauskoppelelemente elektrisch leitend zu kontaktieren, und erfordert, dass diese eine gewisse Mindestgröße aufweisen.

In der Druckschrift J. W. Yang et al., "Selective Area deposited blue GaN-InGaN multiple-quantum well light emitting diodes over silicon substrates", Applied Physics Letters, Bd. 76, Nr. 3 (17.01.2000), S. 273-275, XP-120025677, wird ein Verfahren beschrieben, bei dem lichtemittierende Halbleiterchips selektiv in fotolithografisch hergestellten Öffnungen einer SiO₂-Maskenschicht aufgewachsen werden.

In der Druckschrift Noriyuki Miyata et al., "Selective growth of nanocrystalline Si dots using an ultrathin-Sioxide/oxynitride mask" wird ein Verfahren beschrieben, bei dem in einer Maskenmaterialschicht nach dem Aufwachsen durch einen gebündelten Elektronenstrahl Fenster erzeugt werden, in denen anschließend nanokristalline Silizium-Dots aufgewachsen werden.

In der Druckschrift EP 0 472 221 A2 wird ein Verfahren zur Herstellung eines Streifenlasers beschrieben, bei dem Halbleitermaterial in den Fenstern einer Maskenschicht abgeschieden wird.

Der vorliegenden Erfindung liegt die Aufgabe zugrunde, ein verbessertes Verfahren zur Herstellung von optoelektronischen Halbleiterchips der eingangs genannten Art bereitzustellen, mit dem insbesondere ein Halbeleiterchip mit einer verbesserten Auskopplung der erzeugten elektromagnetischen Strahlung hergestellt werden kann. Eine weitere Aufgabe der vorliegenden Erfindung ist das Bereitstellen eines nach einem derartigen Verfahren hergestellten Halbleiterchips, der gegenüber herkömmlichen Halbleiterchips verbesserte Eigenschaften, insbesondere eine verbesserte Strahlungsauskopplung, aufweist.

Diese Aufgaben werden durch ein Herstellungsverfahren mit den Merkmalen von Anspruch 1 bzw. durch einen optoelektronischen Halbleiterchip mit den Merkmalen von Anspruch 11 gelöst. Vorteilhafte Weiterbildungen des Verfahrens sind Gegenstand der abhängigen Ansprüche.

Erfindungsgemäß beinhaltet das Verfahren zur Herstellung einer Vielzahl von optoelektronischen Halbleiterchips der eingangs genannten Art zumindest die folgenden Verfahrensschritte:
Bereitstellen einer Chipverbund-Basis, die ein Substrat sowie eine Aufwachsoberfläche aufweist;
Ausbilden einer Maskenmaterialschicht auf der Aufwachsoberfläche, mit einer Vielzahl von Fenstern, von denen die meisten eine mittlere Ausdehnung von kleiner als oder gleich 1 µm aufweisen, wobei ein Maskenmaterial derart gewählt ist, dass sich ein in einem späteren Verfahrensschritt aufzuwachsendes Halbleitermaterial der Halbleiterschicht auf diesem im Wesentlichen nicht oder im Vergleich zur Aufwachsoberfläche wesentlich schlechter aufwachsen lässt;
im Wesentlichen gleichzeitiges Aufwachsen von Halbleiterschichtenfolgen, die jeweils eine strahlungsemittierende aktive Zone aufweisen, auf innerhalb der Fenster liegenden Bereichen der Aufwachsoberfläche; und
Vereinzeln der Chipverbund-Basis mit aufgebrachtem Material zu Halbleiterchips, die jeweils eine Vielzahl von Strukturelementen aufweisen, wobei die Strukturelemente die Halbleiterschichtenfolgen sind.

Unter Ausdehnung ist in diesem Zusammenhang die Länge eines auf eine Gerade projizierten Fensters zu verstehen, wobei die Gerade in einer Haupterstreckungsebene der Maskenmaterialschicht verläuft. Die mittlere Ausdehnung ist demnach die über alle Richtungen gemittelte Ausdehnung eines Fensters.

Mit kleineren Fenstern in der Maskenmaterialschicht lassen sich kleinere Strukturelemente in einer größeren Flächendichte erzeugen. Dies kann zu verbesserten Eigenschaften des Bauelementes führen, wie etwa verbesserter Auskopplung von in dem Bauelement erzeugter elektromagnetischer Strahlung.

Bevorzugt weist die Chipverbund-Basis zumindest eine epitaktisch auf das Substrat aufgewachsene Halbleiterschicht auf. Die Aufwachsoberfläche ist dabei eine Oberfläche auf der dem Substrat abgewandten Seite der epitaktisch gewachsenen Halbleiterschicht.

Die Chipverbund-Basis weist in einer vorteilhaften Ausführungsform des Verfahrens eine epitaktisch auf das Substrat aufgewachsene Halbleiterschichtfolge auf, die eine elektromagnetische Strahlung emittierende aktive Zone umfasst. Entsprechend ist die Aufwachsoberfläche eine Oberfläche auf der dem Substrat abgewandten Seite der Halbleiterschichtenfolge. Die nachfolgend auf die Aufwachsoberfläche aufgebrachten Halbleiterschichten der Strukturelemente bilden eine Strukturierung, die beispielsweise den Zweck einer verbesserten Auskopplung der in der Chipverbund-Basis erzeugten elektromagnetischen Strahlung erfüllt.

Alternativ oder zusätzlich weisen die Strukturelemente jeweils eine epitaktisch gewachsene Halbleiterschichtfolge mit einer aktiven Zone auf, die elektromagnetische Strahlung emittiert.

Bevorzugte Materialien für die Maskenmaterialschicht weisen SiO₂, SiₓN_{y} oder Al₂O₃ auf.

Nach dem Aufwachsen der Halbleiterschichten der Strukturelemente wird auf diese bevorzugt eine Schicht aus elektrisch leitendem Kontaktmaterial aufgebracht, das für eine von der aktiven Zone emittierte elektromagnetische Strahlung durchlässig ist, so dass Halbleiterschichten mehrerer Strukturelemente durch das Kontaktmaterial elektrisch leitend miteinander verbunden werden. Dadurch lassen sich auf einfache Weise elektrische Kontaktstrukturen bilden, durch die zudem ein geringer Anteil an in dem Bauelement erzeugter elektromagnetischer Strahlung absorbiert wird.

In einer Ausführungsform des Verfahrens wird die Maskenmaterialschicht nach dem Aufwachsen der Halbleiterschichten zweckmäßigerweise zumindest teilweise entfernt.

In einer weiteren Ausführungsform des Verfahrens wird nach dem Aufwachsen der Halbleiterschichtenfolgen mit Vorteil alternativ oder zusätzlich zum Entfernen von Maskenmaterial eine Planarisierungsschicht über der Aufwachsoberfläche aufgebracht. Diese kann insbesondere dann zu einer verbesserten Lichtauskopplung führen, wenn für sie ein Material gewählt wird, dessen Brechungsindex kleiner ist als derjenige von angrenzenden Halbleiterschichten.

Die Planarisierungsschicht weist bevorzugt ein Material auf, das dielektrische Eigenschaften hat.

Beim Aufwachsen der Halbleiterschichten der Strukturelemente werden die Aufwachsbedingungen bevorzugt derart eingestellt und alternativ oder zusätzlich während des Aufwachsens variiert, dass die Halbleiterschichten mit einer für die Auskopplung von elektromagnetischer Strahlung vorteilhaften Form, beispielsweise einer zumindest näherungsweise linsenartigen Form gebildet werden.

Das Aufwachsen der Maskenmaterialschicht und der Halbleiterschichten erfolgt besonders bevorzugt mittels Metallorganischer Gasphasenepitaxie (MOVPE).

Der optoelektronische Halbleiterchip zeichnet sich dadurch aus, dass er nach dem erfindungsgemäßen Verfahren oder einer Ausführungsform von diesem hergestellt ist. Insbesondere umfasst der Halbleiterchip ein Substrat und eine Aufwachsoberfläche mit einer Maskenmaterialschicht, wobei die Maskenmaterialschicht eine Vielzahl von Fenstern aufweist, von denen die meisten eine mittlere Ausdehnung von kleiner als oder gleich 1 µm aufweisen. Der Halbleiterchip weist eine Vielzahl von Strukturelementen auf, die auf innerhalb der Fenster liegenden Bereichen der Aufwachsoberfläche angeordnet sind, wobei die Strukturelemente jeweils durch eine epitaktisch gewachsene Halbleiterschichtenfolge gebildet sind, die eine elektromagnetische Strahlung emittierende aktive Zone aufweist.

Weitere Vorteile, bevorzugte Ausführungsformen und Weiterbildungen des Verfahrens bzw. des optoelektronischen Halbleiterchips ergeben sich aus den im folgenden in Verbindung mit den Figuren 1a bis 3 erläuterten Ausführungsbeispielen. Es zeigen:
Figuren 1a bis 1d eine schematische Draufsicht auf einen Ausschnitt einer Aufwachsoberfläche während verschiedenen Stadien eines Ausführungsbeispiels des Verfahrens,
Figur 2 eine schematische Schnittansicht eines Ausschnittes eines ersten Ausführungsbeispieles des optoelektronischen Bauelements und
Figur 3 eine schematische Schnittansicht eines Ausschnittes eines zweiten Ausführungsbeispieles des optoelektronischen Bauelements.

In den Ausführungsbeispielen und Figuren sind gleiche oder gleichwirkende Bestandteile jeweils mit den gleichen Bezugszeichen versehen. Die dargestellten Bestandteile sowie die Größenverhältnisse der Bestandteile untereinander sind nicht als maßstabsgerecht anzusehen. Vielmehr sind einige Details der Figuren zum besseren Verständnis übertrieben groß dargestellt.

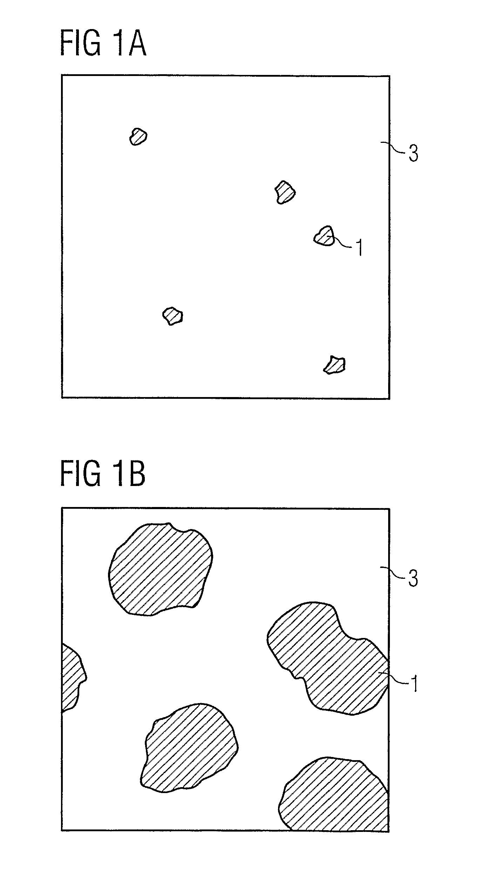

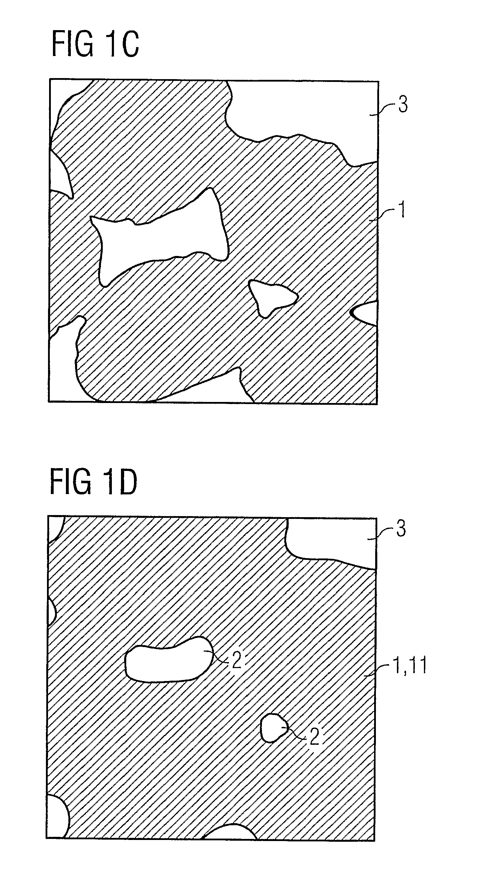

In den Figuren 1a bis 1d ist in chronologischer Abfolge jeweils ein Ausschnitt einer Aufwachsoberfläche 3 während des Aufwachsens einer Maskenmaterialschicht 11 aus einem Maskenmaterial 1 gezeigt. Dabei wird die Maskenmaterialschicht 11 in situ in einer nicht geschlossenen Schicht derart aufgewachsen, dass eine Vielzahl statistisch verteilter Fenster entsteht. "In situ" bedeutet, dass das Aufwachsen in dem selben Epitaxiereaktor erfolgt wie das Aufwachsen von Halbleiterschichten des Bauelementes. Alternativ kann auch eine geschlossene Maskenmaterialschicht aufgewachsen werden, in der nachfolgend mittels Fotolithographie und Ätzen Fenster gebildet werden.

Die Aufwachsoberfläche 3 kann beispielsweise eine Fläche eines Substrates aus n-GaAs sein, das Maskenmaterial 1 besteht z.B. aus SiₓN_{y}.

Das Wachstum des Maskenmaterials 1 beginnt an vereinzelten Punkten der Aufwachsoberfläche 3, an denen sich Kristallite aus Maskenmaterial 1 bilden. Die Kristallite aus Maskenmaterial 1 wachsen im weiteren Verlauf lateral zusammen (siehe Figuren 1b bis 1d), wobei die Wachstumsbedingungen beispielsweise derart eingestellt werden können, dass zweidimensionales Wachstum überwiegt, d.h., dass die Kristallite aus Maskenmaterial 1 überwiegend in einer Ebene parallel zur Aufwachsoberfläche wachsen und nur in geringerem Maße senkrecht dazu. Alternativ kann durch entsprechendes Einstellen der Wachstumsbedingungen auch überwiegend dreidimensionales Wachstum der Kristallite erreicht werden, d.h. ein Wachstum, bei dem die Wachstumsrate in allen möglichen Wachstumsrichtungen ähnlich groß bzw. von einer gleichen Größenordnung ist.

Unter Wachstumsbedingungen sind dabei von außen einstellbare, kontrollierbare bzw. änderbare Parameter wie z.B. Druck, Temperatur, Materialfluß und Wachstumsdauer im Epitaxiereaktor zu verstehen. Die genauen Werte für derartige Parameter zur Erzielung einer bestimmten Aufwachs-Charakteristik können stark variieren und hängen beispielsweise von der Aufteilung und den geometrischen Abmessungen des Epitaxiereaktors oder von dem aufzuwachsenden Material ab.

Mit dem Einstellen der Wachstumsbedingungen lassen sich beim Aufwachsen der Maskenmaterialschicht nicht nur die Form oder die Größe der Fenster variieren, sondern es lässt sich beispielsweise auch mit Vorteil die Flächendichte einstellen, mit der die Fenster auf der Aufwachsoberfläche erzeugt werden.

Die Herstellung einer nicht geschlossenen SiₓN_{y}-Schicht erfolgt beispielsweise in einem MOVPE-Reaktor durch Zuschalten von SiH₄ und NH₃ bei geeigneter Reaktortemperatur, die typischerweise in einem Bereich zwischen 500 und 1100°C liegen kann. Die Reaktortemperatur kann aber auch oberhalb oder unterhalb dieses Bereichs liegen. Solche Verfahren sind etwa in Hageman, P. R. et al, phys. stat. sol. (a) 188, No. 2 (2001), 659-662 beschrieben, dessen Inhalt insofern hiermit durch Rückbezug aufgenommen wird. Alternativ kann als Si-Quelle auch Tetraethyl-Silizium (Si(C₂H₅)₄) oder eine ähnliche Sihaltige Verbindung, die sich für die Epitaxie eignet, verwendet werden.

Bei dem in Figur 1d gezeigten Stadium des Aufwachsens ist die Maskenmaterialschicht 11 fertig ausgebildet. Sie weist eine Vielzahl statistisch verteilter Fenster 2 mit variierenden Formen und Öffnungsflächen auf. Die Abscheidebedingungen werden so gewählt, dass die meisten der Fenster eine mittlere Ausdehnung von kleiner als 1 µm aufweisen. Durch eine kleine Ausdehnung der Fenster können mehr und kleinere Strukturelemente erzeugt und z.B. eine verbesserte Strahlungsauskopplung aus den Bauelementstrukturen erreicht werden.

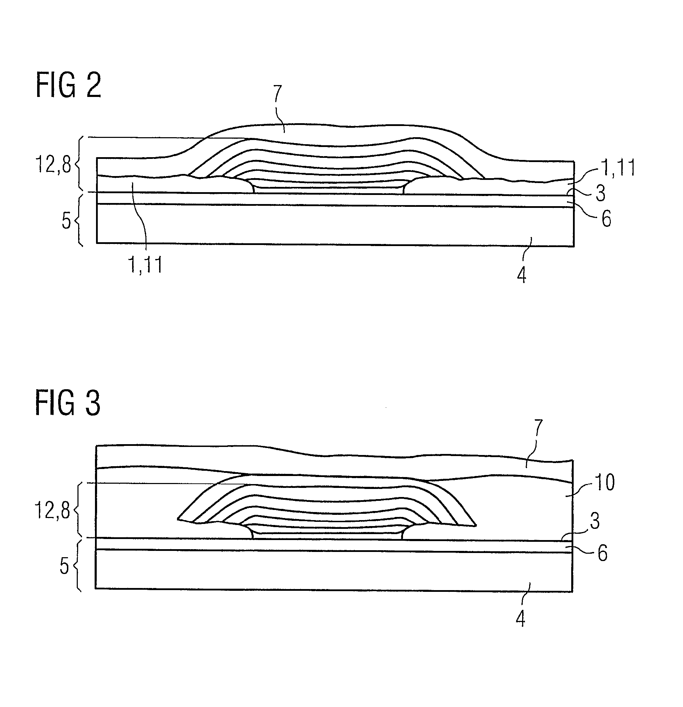

Auf innerhalb dieser Fenster 2 liegenden Bereichen der Aufwachsoberfläche 3 werden nachfolgend beispielsweise Halbleiterschichtfolgen 8 selektiv abgeschieden (siehe Figur 2 oder 3). Diese können etwa auf Phosphid-Verbindungshalbleitern basierend sein und vorzugsweise Materialien InₙGaₘAl₁₋ₙ₋ₘP aufweisen, wobei 0 ≤ n ≤ 1, 0 ≤ m ≤ 1 und n+m ≤ 1. Dabei können diese Materialien ein oder mehrere Dotierstoffe sowie zusätzliche Bestandteile aufweisen, die die physikalischen Eigenschaften des Materials im Wesentlichen nicht ändern.

Eine Halbleiterschichtfolge 8 bildet ein Strukturelement 12. Im Sinne der Erfindung ist es dabei auch möglich, dass Halbleiterschichten mehrerer Strukturelemente überlappen bzw. dass mehrere Strukturelemente zumindest eine gemeinsame Halbleiterschicht aufweisen. Dies ist beispielsweise der Fall, wenn Halbleiterschichtenfolgen 8 so weit lateral über die Maskenmaterialschicht wachsen, dass Halbleiterschichten benachbarter Strukturelemente 12 teilweise oder ganz zusammenwachsen. In derartigen Fällen verläuft eine Grenze zwischen zwei benachbarten Strukturelementen entlang einer Linie, entlang der auf der Maskenmaterialschicht befindliches Halbleitermaterial eine minimale Dicke aufweist.

In Figur 2 weist die das Strukturelement 12 bildende Halbleiterschichtfolge 8 eine aktive Zone auf, die bei Beaufschlagung mit Strom elektromagnetische Strahlung emittiert. Ein Strukturelement 12 kann jedoch auch keine aktive Zone aufweisen und z.B. aus nur einer Halbleiterschicht gebildet sein, die eine linsenartige Form aufweist.

Die aktive Zone kann einen herkömmlichen pn-Übergang aufweisen, beispielsweise für eine Lumineszenzdiode. Solche Strukturen sind dem Fachmann bekannt und werden von daher an dieser Stelle nicht näher erläutert.

Dadurch, dass die Fenster unterschiedlich große Öffnungsflächen aufweisen, ergeben sich für die darin abgeschiedenen Schichten der Halbleiterschichtfolgen 8 unterschiedliche Materialzusammensetzungen. Bei elektromagnetische Strahlung emittierenden Strukturen ergeben sich somit unterschiedliche Emissionsspektren, so dass sich mit derartigen strahlungsemittierenden Bauelementen insgesamt ein breiteres Emissionsspektrum erreichen lässt als mit herkömmlichen Bauelementen.

In Figur 2 ist eine schematische Schnittansicht eines Ausschnittes eines mit dem Verfahren hergestellten optoelektronischen Bauelementes gezeigt. Die Chipverbund-Basis 5 umfasst ein Substrat 4 sowie eine auf diesem Substrat epitaktisch aufgewachsene Halbleiterschicht oder Halbleiterschichtfolge 6, deren von dem Substrat 4 abgewandte Seite die Aufwachsoberfläche 3 bildet. Auf der Aufwachsoberfläche 3 ist eine Maskenmaterialschicht 11 aufgewachsen, die in dem gezeigten Ausschnitt des Bauelementes ein Fenster aufweist, in das eine Halbleiterschichtfolge 8 selektiv abgeschieden ist.

Die maximale Dicke der Maskenmaterialschicht 11 kann z.B. nur einige nm betragen und ist geringer als die Höhe der Halbleiterschichtfolge 8. Dadurch werden Halbleiterschichten der Halbleiterschichtfolge 8 ab einer Höhe, die größer ist als die Dicke der sie umgebenden Maskenmaterialschicht 11, durch laterales Wachstum auch teilweise über der Maskenmaterialschicht 11 aufgewachsen.

Die Aufwachsbedingungen zum Aufwachsen der Halbleiterschichtfolge 8 werden z.B. derart gewählt oder während des Aufwachsens variiert, dass die Halbleiterschichtfolge 8 mit einer linsenartigen Form gebildet werden. Alternativ kann diese Form auch kegelstumpfartig oder polyederartig sein.

Der Begriff Aufwachsbedingungen ist in diesem Zusammenhang ähnlich zu verstehen wie beim vorhergehend erläuterten Aufwachsen von Maskenmaterial 1. Dabei hängt es neben der Art des aufzuwachsenden Halbleitermaterials und der Art der Epitaxieanlage auch stark von der Art des Maskenmaterials 1 ab, wie genau sich das Einstellen bestimmter Werte für Parameter wie Druck, Temperatur, Materialfluß und Wachstumsdauer auf das Wachstum von Halbleitermaterialien auswirkt.

Bei dem in Figur 2 dargestellten Ausführungsbeispiel überdeckt die zuletzt aufgewachsene Halbleiterschicht alle übrigen Halbleiterschichten der Halbleiterschichtenfolge 8. Dies ermöglicht es, eine Schicht aus elektrisch leitfähigem Kontaktmaterial 7 beispielsweise flächig über der gesamten Aufwachsoberfläche 3 bzw. auf der Halbleiterschichtfolge 8 und dem Maskenmaterial 1 aufzubringen, ohne dass verschiedene Halbleiterschichten der Halbleiterschichtfolge 8 elektrisch kurzgeschlossen werden. Als Kontaktmaterial 7 eignet sich beispielsweise Indiumzinnoxid (ITO) oder auch eine wenige Atomlagen dicke Metallschicht, beispielsweise aus Platin, die durch ihre geringe Dicke für eine von der aktiven Zone der Halbleiterschichtfolge 8 emittierte Strahlung durchlässig ist.

Ein Kontaktmaterial mit ITO kann zusätzlich eine derartige dünne Metallschicht aufweisen, die vor dem ITO abgeschieden wird. Dadurch kann die elektrische Leitfähigkeit des Kontaktes zwischen Kontaktmaterial 7 und Halbleiterschichtfolge 8 verbessert werden.

Damit sich zwischen dem Kontaktmaterial 7 und der Halbleiterschichtfolge 8 ein elektrisch leitender Kontakt ausbildet, muss das Bauelement nach Aufbringen des Kontaktmaterials 7 in der Regel bei einer geeigneten Temperatur ausreichend lang getempert werden. Diese Maßnahmen sind dem Fachmann bekannt und werden von daher nicht näher erläutert.

Auf das Kontaktmaterial 7 kann vor oder nach dem Tempern ein Bondpad aufgebracht werden, über das die Halbleiterschichtfolge von einer Seite her z.B. mittels eines Bonddrahts kontaktiert werden kann (nicht gezeigt).

Wenn das Substrat 4 rückseitig, d.h. auf der von der Aufwachsoberfläche abgewandten Seite, mit einem Kontaktmaterial versehen und elektrisch leitend verbunden ist, dann kann man über das Bondpad und den Rückseitenkontakt direkt an die noch im Verbund befindlichen Bauelemente eine Spannung anlegen und ihre Funktionsfähigkeit testen (Direct Probing).

Bei dem Bauelement des in Figur 2 gezeigten Ausschnittes kann alternativ oder zusätzlich auch die auf dem Substrat 4 angeordnete Halbleiterschichtfolge 6 eine elektromagnetische Strahlung emittierende, aktive Zone aufweisen. Bei Anlegen einer Spannung an das Bauelement wird der Strom durch die Maskenmaterialschicht 11 auf einen Bereich der Fenster 2 beschränkt, so dass ein Lichterzeugungsbereich im Wesentlichen auf einen Teil der aktiven Zone der Halbleiterschichtfolge 6 beschränkt ist, der unterhalb eines Fensters 2 liegt.

In Figur 3 ist der Ausschnitt eines zweiten Ausführungsbeispieles des Bauelements gezeigt. Im Unterschied zu dem anhand Figur 2 erläuterten Ausführungsbeispiel beinhaltet das Verfahren zur Herstellung in diesem Beispiel nach dem Aufbringen der Halbleiterschichtfolge 8 ein Entfernen der Maskenmaterialsschicht 11, was durch selektives Ätzen erfolgen kann.

Nachfolgend wird auf die Aufwachsoberfläche 3 und die Halbleiterschichtfolge 8 eine Planarisierungsschicht 10 aufgebracht, die z.B. aus einem Dielektrikum bestehen kann, dessen Brechungsindex kleiner ist als der von Materialien der Halbleiterschichtfolge 8.

Damit die Halbleiterschichtfolge 8 elektrisch leitend kontaktiert werden kann, wird die Planarisierungsschicht 10 im Folgenden zumindest teilweise abgedünnt oder entfernt, so dass die äußerste Schicht der Halbleiterschichtfolge 8 freigelegt wird. Auf diese wird nachfolgend analog dem anhand Figur 2 erläuterten Ausführungsbeispiel elektrisch leitendes Kontaktmaterial 7 aufgebracht und getempert.

Nachfolgend kann die Chipverbund-Basis 5 mit dem aufgebrachten Material zu einer Vielzahl optoelektronischer Halbleiterchips vereinzelt werden. Jeder dieser Halbleiterchips umfasst eine Vielzahl von Strukturelementen 12.

Der Schutzumfang der Erfindung ist nicht durch die Beschreibung der Erfindung anhand der Ausführungsbeispiele beschränkt. Beispielsweise lassen sich die Fenster in der Maskenmaterialschicht derart klein ausbilden, dass in ihnen quasi eindimensionale Halbleiterbauelement-Strukturen aufgewachsen werden.

## Patentansprüche

1. Verfahren zur Herstellung einer Vielzahl von optoelektronischen Halbleiterchips, wobei das Verfahren zumindest die folgenden Verfahrensschritte umfasst:
- Bereitstellen einer Chipverbund-Basis, die ein Substrat sowie eine Aufwachsoberfläche aufweist;
- Ausbilden einer Maskenmaterialschicht auf der Aufwachsoberfläche, mit einer Vielzahl von Fenstern, wobei ein Maskenmaterial derart gewählt wird, dass sich ein in einem späteren Verfahrensschritt aufzuwachsendes Halbleitermaterial der Halbleiterschicht auf diesem im Wesentlichen nicht oder im Vergleich zur Aufwachsoberfläche wesentlich schlechter aufwachsen lässt;
- im Wesentlichen gleichzeitiges Aufwachsen von Halbleiterschichtenfolgen, die jeweils eine strahlungsemittierende aktive Zone aufweisen, auf innerhalb der Fenster liegenden Bereichen der Aufwachsoberfläche; und
- Vereinzeln der Chipverbund-Basis mit aufgebrachtem Material zu Halbleiterchips, so dass
- die Halbleiterchips jeweils eine Vielzahl von Strukturelementen aufweisen, wobei die Strukturelemente die Halbleiterschichtenfolgen sind, **dadurch gekennzeichnet, dass**
- die meisten der Fenster eine mittlere Ausdehnung von kleiner als oder gleich 1µm aufweisen.

2. Verfahren nach einem der vorhergehenden Ansprüche,
bei dem das Maskenmaterial SiO₂, SiₓN_{y} oder Al₂O₃ aufweist.

3. Verfahren nach einem der vorhergehenden Ansprüche, bei dem nach dem Aufwachsen der Halbleiterschichten eine Schicht aus elektrisch leitendem Kontaktmaterial, das für eine von der aktiven Zone emittierte elektromagnetische Strahlung durchlässig ist, auf die Halbleiterschichten aufgebracht wird, so dass Halbleiterschichten mehrerer Strukturelemente durch das Kontaktmaterial elektrisch leitend miteinander verbunden werden.

4. Verfahren nach einem der vorhergehenden Ansprüche, bei dem die durchschnittliche Dicke der Maskenmaterialschicht geringer ist als die summierte Dicke der Halbleiterschichten eines Strukturelementes.

5. Verfahren nach einem der vorhergehenden Ansprüche, bei dem die Maskenmaterialschicht nach dem Aufwachsen der Halbleiterschichten zumindest teilweise entfernt wird.

6. Verfahren nach einem der vorhergehenden Ansprüche, bei dem nach dem Aufwachsen der Halbleiterschichtenfolgen eine Planarisierungsschicht über der Aufwachsoberfläche aufgebracht wird.

7. Verfahren nach Anspruch 6, bei dem
für die Planarisierungsschicht ein Material gewählt wird, dessen Brechungsindex kleiner ist als der der Halbleiterschichten.

8. Verfahren nach Anspruch 6 oder 7, bei dem
für die Planarisierungsschicht ein Material gewählt wird, das dielektrische Eigenschaften hat.

9. Verfahren nach einem der vorhergehenden Ansprüche,
bei dem die Aufwachsbedingungen zum Aufwachsen der Halbleiterschichten derart eingestellt und/oder während des Aufwachsens variiert werden, dass Halbleiterschichten der Strukturelemente eine linsenartige, eine kegelstumpfartige oder eine polyederartige Form bilden.

10. Verfahren nach einem der vorhergehenden Ansprüche,
bei dem das Aufwachsen der Halbleiterschichten mittels Metallorganischer Gasphasenepitaxie erfolgt.

11. Optoelektronischer Halbleiterchip,
umfassend ein Substrat und eine Aufwachsoberfläche mit einer Maskenmaterialschicht, wobei
- die Maskenmaterialschicht eine Vielzahl von Fenstern aufweist, und
- der Halbleiterchip eine Vielzahl von Strukturelementen aufweist, die auf innerhalb der Fenster liegenden Bereichen der Aufwachsoberfläche angeordnet sind, wobei die Strukturelemente jeweils eine durch eine epitaktisch gewachsene Halbleiterschichtenfolge gebildet sind, die eine elektromagnetische Strahlung emittierende aktive Zone aufweist, **dadurch gekennzeichnet, dass** die meisten der Fenster eine mittlere Ausdehnung von kleiner als oder gleich 1 µm aufweisen.

12. Optoelektronischer Halbleiterchip nach Anspruch 11,
bei dem die Vielzahl der Strukurelemente durch eine Schicht aus elektrisch leitendem Kontaktmaterial, das für eine von der aktiven Zone emittierte elektromagnetische Strahlung durchlässig ist, elektrisch leitend miteinander verbunden sind.

## Claims

1. Method for the production of a plurality of optoelectronic.semiconductor chips, the method comprising at least the following method steps:
- provision of a chip composite base having a substrate and a growth surface;
- formation of a mask material layer on the growth surface, with a multiplicity of windows, a mask material being chosen in such a way that a semiconductor material of the semiconductor layer that is to be grown in a later method step essentially cannot grow on said mask material or can grow in a substantially worse manner in comparison with the growth surface;
- essentially simultaneous growth of semiconductor layer sequences, which each have a radiation-emitting active zone, on regions of the growth surface that lie within the windows; and
- singulation of the chip composite base with applied material to form semiconductor chips, such that
- the semiconductor chips respectively have a multiplicity of structural elements, the structural elements being the semiconductor layer sequences, **characterized in that**
- most of the windows have an average extent of less than or equal to 1 µm.

2. Method according to claim 1, in which the mask material has SiO₂, SiₓN_{y} or Al₂O₃.

3. Method according to one of the preceding claims, in which, after the growth of the semiconductor layers, a layer made of electrically conductive contact material that is transmissive to an electromagnetic radiation emitted by the active zone is applied to the semiconductor layers, so that semiconductor layers of a plurality of structural elements are electrically conductively connected to one another by the contact material.

4. Method according to one of the preceding claims, in which the average thickness of the mask material layer is less than the cumulated thickness of the semiconductor layers of a structural element.

5. Method according to one of the preceding claims, in which the mask material layer is at least partly removed after the growth of the semiconductor layers.

6. Method according to one of the preceding claims, in which, after the growth of the semiconductor layer sequences, a planarization layer is applied over the growth surface.

7. Method according to claim 6, in which a material whose refractive index is lower than that of the semiconductor layers is chosen for the planarization layer.

8. Method according to claim 6 or 7, in which a material which has dielectric properties is chosen for the planarization layer.

9. Method according to one of the preceding claims, in which the growth conditions for the growth of the semiconductor layers are set and/or varied during growth in such a way that semiconductor layers of the structural elements form a lenslike, a truncated-conelike or a polyhedral form.

10. Method according to one of the preceding claims, in which the semiconductor layers are grown by means of metal organic vapor phase epitaxy.

11. Optoelectric semiconductor chip, comprising a substrate and a growth surface with a mask material layer,
wherein
- the mask material layer has a multiplicity of windows, and
- the semiconductor chip has a multiplicity of structural elements arranged on regions of the growth surface that lie within the windows, the structural elements respectively being formed by an epitaxially grown semiconductor layer sequence having an active zone that emits electromagnetic radiation,
**characterized in that**
most of the windows have an average extent of less than or equal to 1 µm.

12. Optoelectric semiconductor chip according to claim 11,
in which the multiplicity of structural elements are electrically conductively connected to one another by a layer made of electrically conductive contact material that is transmissive to an electromagnetic radiation emitted by the active zone.

## Revendications

1. Procédé pour la fabrication d'une pluralité de puces optoélectroniques à semi-conducteur, le procédé comprenant au moins les étapes de processus suivantes:
- disposition d'une base-composite de puce qui comporte un substrat ainsi qu'une surface de croissance;
- formation d'une couche de matériau de masque sur la surface de croissance, avec une pluralité de fenêtres, en choisissant un matériau de masque de manière que sur celui-ci un matériau semi-conducteur de la couche de semi-conducteur croissant dans une étape ultérieure de processus ne puisse pratiquement pas croître ou ne puisse croître que beaucoup moins bien en comparaison de la surface de croissance;
- croissance pratiquement simultanée de successions de couches de semi-conducteur qui comportent chacune une zone active émettant un rayonnement, sur des zones de la surface de croissance qui se trouvent à l'intérieur des fenêtres; et
- isolement de la base-composite de puce avec le matériau appliqué, pour l'obtention de puces à semi-conducteur, de sorte que
- les puces à semi-conducteur comportent chacune plusieurs éléments structuraux, les éléments structuraux étant les successions de couches de semi-conducteur,
**caractérisé en ce que**
la plupart des fenêtres présentent une extension moyenne inférieure ou égale à 1 µm.

2. Procédé selon la revendication 1,
dans lequel le matériau de masque comporte SiO₂, SiₓN_{y} ou Al₂O₃.

3. Procédé selon l'une quelconque des revendications précédentes, dans lequel
après la croissance des couches de semi-conducteur on applique sur les couches de semi-conducteur une couche de matériau de contact conducteur de l'électricité, qui est transparent à un rayonnement électromagnétique émis par la zone active, de sorte que des couches de semi-conducteur de plusieurs éléments structuraux sont reliées entre elles en conduisant l'électricité par le matériau de contact.

4. Procédé selon l'une quelconque des revendications précédentes, dans lequel
l'épaisseur moyenne de la couche de matériau de masque est plus faible que la somme des épaisseurs des couches de semi-conducteur d'un élément structural.

5. Procédé selon l'une quelconque des revendications précédentes, dans lequel
après la croissance des couches de semi-conducteur on élimine au moins en partie la couche de matériau de masque.

6. Procédé selon l'une quelconque des revendications précédentes, dans lequel
après la croissance de la succession de couches de semi-conducteur on applique une couche de planarisation sur la surface de croissance.

7. Procédé selon la revendication 6, dans lequel pour la couche de planarisation on choisit un matériau dont l'indice de réfraction est inférieur à celui des couches de semi-conducteur.

8. Procédé selon la revendication 6 ou 7, dans lequel pour la couche de planarisation on choisit un matériau qui a des propriétés diélectriques.

9. Procédé selon l'une quelconque des revendications précédentes,
dans lequel on ajuste et/ou fait varier pendant la croissance les conditions de croissance pour la croissance des couches de semi-conducteur de manière que les couches de semi-conducteur des éléments structuraux acquièrent une forme lenticulaire, une forme tronconique ou une forme polyédrique.

10. Procédé selon l'une quelconque des revendications précédentes,
dans lequel la croissance des couches de semi-conducteur s'effectue au moyen d'épitaxie en phase gazeuse aux organométalliques.

11. Puce optoélectronique à semi-conducteur, comprenant un substrat et une surface de croissance avec une couche de matériau de masque,
dans laquelle
- la couche de matériau de masque présente une pluralité de fenêtres, et
- la puce à semi-conducteur comporte plusieurs éléments structuraux qui sont disposés sur des zones de la surface de croissance qui se trouvent à l'intérieur des fenêtres, les éléments structuraux étant constitués chacun par une succession de couches de semi-conducteur à croissance épitactique, qui présente une zone active émettant un rayonnement électromagnétique,
**caractérisée en ce que**
la plupart des fenêtres présentent une extension moyenne inférieure ou égale à 1 µm.

12. Puce optoélectronique à semi-conducteur selon la revendication 11, dans laquelle lesdits plusieurs éléments structuraux sont reliés entre eux en conduisant l'électricité par une couche de matériau de contact conducteur de l'électricité, qui est transparent à un rayonnement électromagnétique émis par la zone active.
